# EUROPEAN PATENT SPECIFICATION

(11) **EP 1 840 330 B1**
(45) Date of publication and mention of the grant of the patent: **24.03.2010**
(21) Application number: 07251279.1
(22) Date of filing: 26.03.2007
(51) Int. Cl.: F01D 5/18

(54) **Turbulator arrangement for passageways**
Turbulatoranordnung für Strömungsdurchgänge
Agencement de turbulateurs pour passages d' écoulement

(30) Priority: 24.03.2006 US 388815
(43) Date of publication of application: 03.10.2007
(73) Proprietor: United Technologies Corporation, Hartford, CT 06101 (US)
(72) Inventor: Abdel-Messeh, William, Middletown, CT 06457 (US); Cunha, Frank J., Avon, CT 06001 (US)
(74) Representative: Leckey, David Herbert

(56) References cited:
- EP-A- 1 136 651
- WO-A-01/71164

## Description

### BACKGROUND OF THE INVENTION

### (1) Field of the Invention

The present invention relates to advanced turbulator arrangements for cooling microcircuits used in turbine engine components.

### (2) Prior Art

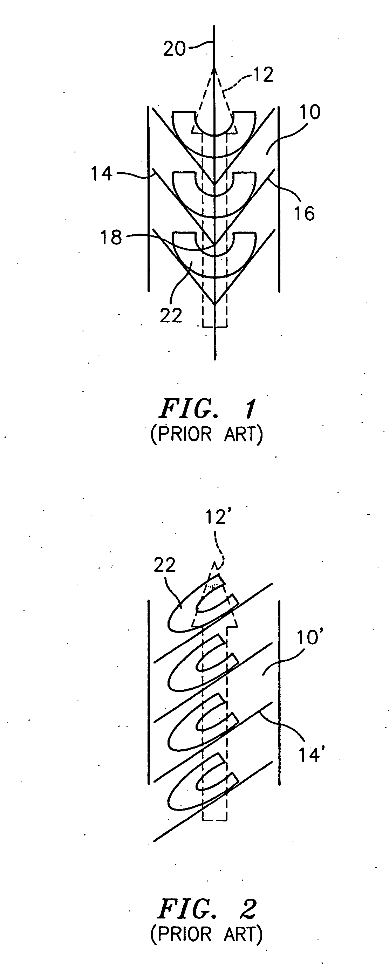

Turbulation devices have been used in cooling passageways as a way of increasing the heat being transferred. Typically, the previous trip-strip turbulation designs have centered around the designs shown in FIGS. 1 and 2. As shown in FIG. 1, a cooling passageway 10 having cooling fluid flowing in the direction 12 have had a pair of trip strips 14 and 16 forming a chevron design with the apex 18 of the chevron being along the flow direction 12 and the symmetrical axis 20 being parallel to the flow direction 12.

Referring now to FIG. 2, there is shown an alternative prior art turbulation system having a cooling passageway 10' with a cooling fluid flowing in the direction 12'. As can be seen from this figure, a plurality of trip strips 14' are arranged at an angle less than 90 degrees with respect to the flow direction 12'.

The contours 22 in the embodiments of FIGS. 1 and 2 illustrate areas of higher turbulence in the coolant flow field, and therefore more heat transfer pick-up. The heat transfer enhancement relative to channel flow with smooth walls is about two to three times the heat transfer obtained from the smooth channel flow depending on the Reynolds number for the coolant flow. The enhancement shown in FIGS. 1 and 2 is only local and washes away from its peak value either at the junction or apex 18 of the trip strips 14 and 16 in the chevron arrangement of FIG. 1 or close to the wall in an angled trip strip arrangement as shown in FIG. 2.

It is therefore desirable to extend the heat transfer regions that usually occur at the trip-strip junctions, either with other trip strips or connecting walls.

Passageways having the features of the preamble of claim 1 are disclosed in WO 01/71164 and EP-A-1136651.

### SUMMARY OF THE INVENTION

In accordance with the present invention, there is provided a turbulation arrangement for a cooling passageway which extends the heat transfer region to substantially the entire cooling surface area.

More particularly in accordance with the present invention, a passageway through which a fluid flows in a first direction is provided as claimed in claim 1.

Other details of the advanced turbulator arrangements for microcircuits of the present invention, as well as other advantages attendant thereto, are set forth in the following detailed description and the accompanying drawings, wherein like reference numerals depict like elements.

### BRIEF DESCRIPTION OF THE DRAWINGS

FIG. 1 is a schematic representation of a prior art turbulation arrangement in a cooling passageway for increasing heat transfer;
FIG. 2 is a schematic representation of another prior art turbulation arrangement in a cooling passageway for increasing heat transfer;
FIG. 3 is a schematic representation of a turbulation arrangement for a cooling passageway in accordance with the present invention;
FIG. 4 is a schematic representation of the turbulation arrangement of FIG. 3 when fluid first forms two cells;
FIG. 5 is a schematic representation of the turbulation arrangement of FIG. 3 where the flows of the two cells merge;
FIG. 6 is a schematic representation of the turbulation arrangement of FIG. 3 showing the fluid cell spreading throughout the region between the adjacent trip strips in the turbulation arrangement;
FIG. 7 is a schematic representation of an alternative turbulation arrangement in accordance with the present invention; and
FIG. 8 is a schematic representation of yet another alternative turbulation arrangement in accordance with the present invention.

### DETAILED DESCRIPTION OF THE PREFERRED EMBODIMENT(S)

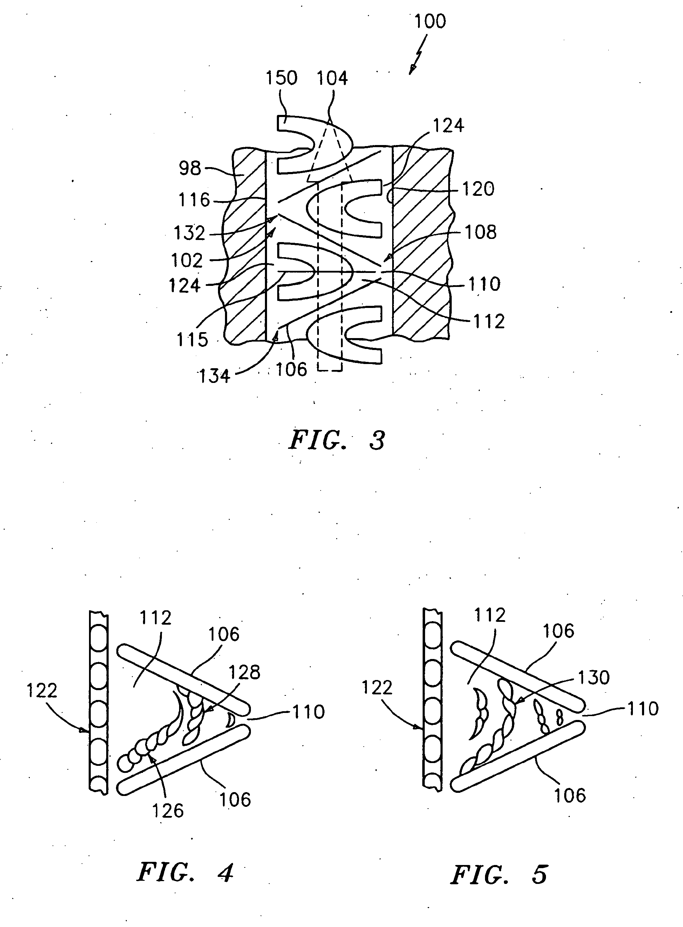

The present invention relates to a cooling passageway having an improved turbulation arrangement. As shown in FIG. 3, the cooling passageway may be a portion of a cooling microcircuit (not shown) within a part 98, such as a turbine engine component.

Referring now to FIG. 3, there is shown a first turbulation arrangement 100 in accordance with the present invention. The turbulation arrangement 100 is provided within a passageway 102 in which a fluid, such as a cooling fluid, flows in a direction 104. The turbulation arrangement comprises a plurality of trip strips 106 arranged at an angle with respect to the flow direction 104. Adjacent ones of the trip strips 106 are arranged so that they converge towards each other and form an apex portion 108 with an opening 110 through which the cooling fluid enters a region 112 bounded by the adjacent ones of the trip strips 106. The apex portion 108 is preferably at an angle, preferably a right angle, with respect to the flow direction 104. A first region 112 in the passageway 102 may have an apex portion 108 adjacent a first wall 116, while a second region 112, adjacent to the first region 112, may have its apex portion 108 adjacent a second wall 120 opposed to the first wall 116.

Each trip strip 106 may be formed using any suitable technique known in the art. The trip strips 106 may be formed on the walls of the passageway 102 so as to wrap around the walls.

The regions 112 are preferably substantially triangularly shaped and are aligned along the flow direction 104. Each region 112 may have a plurality of vertices formed by the apex portion 108 and the trip strips 106 and the wall 116 or 120. Each region 112 preferably has an axis of symmetry 115 that is substantially perpendicular to the flow direction 104. If desired, as shown in FIG. 4, a series of cross over holes 122 may be provided at a base portion 124 of the region 112, which base portion 124 is at a second end of the region 112. The cross-over holes 122 offer a flow path by letting the flow through after or before turbulation. The second end of the region 112 is opposed to the first end where the apex portion 108 is located. The base portion 124 is preferably located near a wall 116, 120.

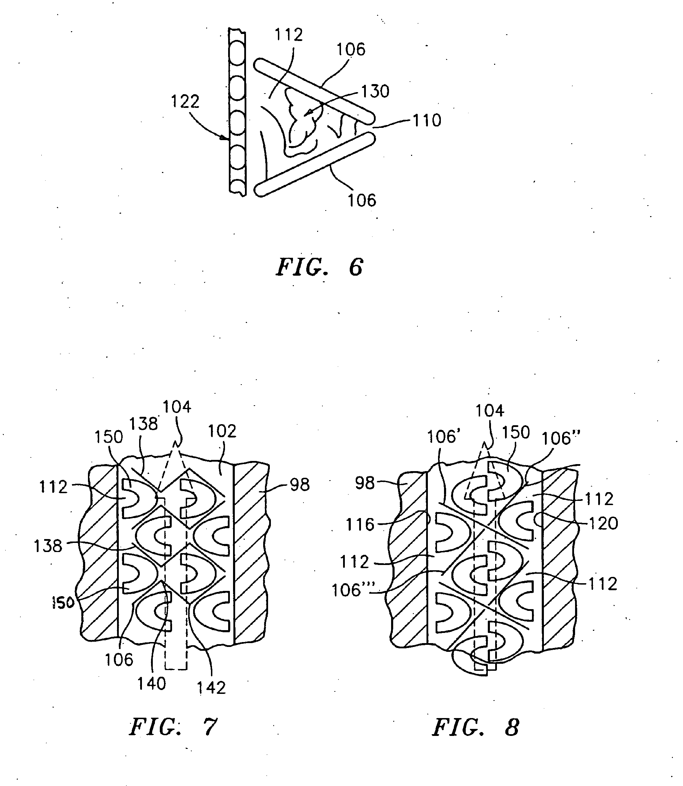

Referring now to FIG. 4, there is shown a representation of a turbulation arrangement in accordance with FIG. 3 having a region 112. As can be seen from the figure, as flow enters the region 112 through the apex opening 110, two fluid cells 126 and 128 are formed. As shown in FIG. 5, as more fluid enters the region 112, the two fluid cells 126 and 128 unite into a single cell 130. Finally, as shown in FIG. 6, the cell 130 spreads throughout the region 112 with the cell 130 occupying most of the area of the region 112. As a result, there is full turbulence within the region 112. Again, the turbulence comes from vortices that start at the apex opening 110 formed by the adjacent trip strips 106 and the junction points 132 and 134 formed by the trip strips 106 and the wall 116 or 120. The vortices are amplified from two out of the three vertices of the triangular shaped region 112 in such a way as to create turbulent cells all over the enclosed two dimensional area of the region 112 formed by the wall 116 and the trip strips 106.

Extending this principle of creating turbulence, FIGS. 7 and 8 illustrate other turbulation arrangements with two or more active junctions to create areas of high heat transfer enhancement everywhere in a cooling passageway. The triangular junction points shown in the embodiments of FIGS. 7 and 8 may be in-phase or out-of-phase with each other. These high turbulence areas lead to an average heat transfer enhancement of two to three times not just locally, but also all over the entire two-dimensional enclosed area of the regions 112.

As shown in FIG. 7, a plurality of regions 112 may be formed by a plurality of rows 138 of trip strips 106 formed within the passageway 102. The rows 138 of trip strips 106 may be positioned along the flow direction 104. Each row 138 of trip strips 106 may comprise three trip strips 106 angled with respect to each other so as to form a pair of intersecting joints 140 and 142. In each row 138, a first of the trip strips may be at a first angle with respect to the flow direction 104, a second of the trip strips may be at a second angle with respect to the flow direction 104, and a third of the trip strips may be at a third angle with respect to the flow direction 104. If desired, each row 138 may have more than three trip strips. Further, if desired, adjacent ones of the trip strips 106 in a row 138 may be spaced from each other to form a gap. In this turbulator arrangement, a plurality of regions 112 may be aligned along an axis transverse to the flow direction 104.

Referring now to FIG. 8, a plurality of regions 112 may be formed by a diamond shaped turbulation arrangement wherein a first trip strip 106' extends from a point near the wall 116 to a point near the wall 120. The rest of each region 112 may be formed by two spaced apart trip strips 106" and 106 "' which are at an angle that intersects the trip strip 106'. In this turbulation arrangement, a plurality of regions 112 may be aligned along an axis at an angle with respect to the flow direction 104.

The contours 150 shown in FIGS. 4, 7, and 8 illustrate the high turbulence areas created in each of the regions 112.

One of the advantages of the turbulation arrangements of the present invention is the creation of a more uniform heat transfer coefficient throughout the cooling passageway. This is because the average heat transfer enhancement is distributed throughout the entire area enclosed by the trip strips as opposed to having a peak enhancement just locally. As a result, a part, such as a turbine engine component, having a cooling passageway will experience less thermal mismatches. Part durability and life will improve with potentially less coolant flow, thus enhancing the performance of the part.

The turbulator arrangements of the present invention may be used in cooling passageways in a wide variety of turbine engine components including, but not limited to, blades, vanes, blade outer air seals, combustor panels, and any other part that contains a cooling passageway.

## Claims

1. A passageway (102) through which a fluid flows in a first direction (104), said passageway comprising:
a plurality of trip strips (106;106',106",106") positioned within the passageway (102); and
adjacent ones of said trip strips being oriented to converge towards each other at a first end to form an apex portion (108) and to form a triangularly shaped region (112) in which turbulence is created; **characterised in that:**
said trip strips (106;106',106",106") are spaced apart at said first end to define an opening (110) in said apex portion through which said fluid enters said region (112);
said apex portion (108) is arranged such that fluid enters said triangularly shaped region (112) through said opening (110) in a direction which is at an angle with respect to said first direction (104); and
fluid entering said opening forms two fluid cells (126, 128) which unite into a single fluid cell (130) as more fluid enters the opening (110), which cell spreads throughout the triangularly shaped region (112) and occupies most of the area of the triangularly shaped region (112) resulting in full turbulence within the triangularly shaped region (112) .

2. The passageway of claim 1 wherein said angle is a right angle.

3. The passageway of claim 1 or 2, wherein said region (112) has a base portion at a second end opposed to said first end and an axis of symmetry (115) between said first end and said second end is transverse to said first direction (104) and wherein said base portion is located near a wall of said passageway.

4. The passageway of any preceding claim, further comprising:
said passageway (102) having first and second opposed walls (116,120); and
said plurality of trip strips (106) forming a plurality of said triangularly shaped regions (112) along the first direction (104), wherein a first of said triangularly shaped regions (112) has its apex portion (108) adjacent a first of said walls (116) and a second of said triangularly shaped regions (112) has its apex portion (108) adjacent a second of said walls (120).

5. The passageway of any of claims 1 to 3, further comprising:
said passageway having first and second opposed walls (116;120); and
said plurality of trip strips (106) form a plurality of regions aligned along an axis transverse to said first direction (104).

6. The passageway of claim 5, wherein said plurality of triangularly shaped regions are formed by at least two rows (138) of trip strips (106), each said row (138) of trip strips having a first trip strip (106) angled at a first angle with respect to said first direction (104), a second trip strip (106) angled at a second angle with respect to said first direction (104), and a third trip strip angled at a third angle with respect to said first direction (104).

7. The passageway of claim 6, wherein each row (138) has two joints (140,142).

8. The passageway of claim 6, further comprising at least one gap between two of said trip strips in at least one of the rows (138).

9. The passageway of any of claims 1 to 4, further comprising:
said passageway having a first wall (116) and a second wall (120) opposed to said first wall (116);
a plurality of said triangularly shaped regions (112) between said walls (116,120); and
said plurality of regions (112) being formed by a first trip (106') strip extending from a first location near one of said walls (116) to a second location near a second one of said walls (120) and by a pair of spaced apart trip strips (106",106"')
positioned at an angle which intersects the first trip strip (106').

10. The passageway of any preceding claim, wherein each said triangularly shaped region (112) has said apex portion and two vertices formed by a pair of said trip strips (106) and a wall (116) of said passageway (102).

11. A part (98) comprising:
a passageway (102) as claimed in any preceding claim.

12. The part according to claim 11, wherein said part (98) comprises a turbine engine component.

13. The part according to claim 11 or 12, wherein said passageway (102) comprises a cooling passageway in which a cooling fluid flows in said first direction (104).

## Patentansprüche

1. Passage (102), durch die ein Fluid in einer ersten Richtung (104) strömt,
wobei die Passage Folgendes aufweist:
eine Mehrzahl von Auslösestreifen (106; 106', 106", 106"), die innerhalb der Passage (102) angeordnet sind; und
wobei einander benachbarte Auslösestreifen derart orientiert sind, dass sie an einem ersten Ende zueinander hin konvergieren, um einen Scheitelbereich (108) zu bilden und um eine dreieckig ausgebildete Region (112) zu bilden, in der Turbulenz erzeugt wird;
**dadurch gekennzeichnet, dass** die Auslösestreifen (106; 106', 106", 106") an dem ersten Ende derart voneinander beabstandet sind, dass in dem Scheitelbereich eine Öffnung (110) gebildet ist, durch die das Fluid in die Region (112) eintritt;
dass der Scheitelbereich (108) derart angeordnet ist, dass Fluid durch die Öffnung (110) in die dreieckig ausgebildete Region (112) in einer Richtung eintritt, die in einem Winkel in Bezug auf die erste Richtung (104) verläuft; und
dass in die Öffnung eintretendes Fluid zwei Fluidzellen (126, 126) bildet, die sich zu einer einzigen Fluidzelle (130) vereinigen, wenn mehr Fluid in die Öffnung (110) eintritt, wobei sich die Zelle über die gesamte dreieckig ausgebildete Region (112) ausbreitet und den größten Teil der Fläche der dreieckig ausgebildeten Region (112) einnimmt, so dass vollständige Turbulenz innerhalb der dreieckig ausgebildeten Region (112) resultiert.

2. Passage nach Anspruch 1,
wobei es sich bei dem Winkel um einen rechten Winkel handelt.

3. Passage nach Anspruch 1 oder 2,
wobei die Region (112) einen Basisbereich an einem zweiten Ende gegenüber von dem ersten Ende aufweist und eine Symmetrieachse (115) zwischen dem ersten Ende und dem zweiten Ende quer zu der ersten Richtung (104) verläuft, und wobei sich der Basisbereich in der Nähe einer Wand der Passage befindet.

4. Passage nach einem der vorausgehenden Ansprüche,
wobei die Passage (102) weiterhin eine erste und eine zweite Wand (116, 120) aufweist, die einander gegenüberliegen; und
wobei die Mehrzahl der Auslösestreifen (106) eine Mehrzahl von dreieckig ausgebildeten Regionen (112) entlang der ersten Richtung (104) bildet,
wobei eine erste von den dreieckig ausgebildeten Regionen (112) mit ihrem Scheitelbereich (108) der ersten Wand (108) benachbart ist und eine zweite von den dreieckig ausgebildeten Regionen (112) mit ihrem Scheitelbereich (108) der zweiten Wand (120) benachbart ist.

5. Passage nach einem der Ansprüche 1 bis 3,
wobei die Passage weiterhin eine erste und eine zweite Wand (116; 120) aufweist, die einander gegenüberliegen; und
wobei die Mehrzahl der Auslösestreifen (106) eine Mehrzahl von Regionen bildet, die entlang einer zu der ersten Richtung (104) quer verlaufenden Achse ausgerichtet sind.

6. Passage nach Anspruch 5,
wobei die Mehrzahl der dreieckig ausgebildeten Regionen durch mindestens zwei Reihen (138) von Auslösestreifen (106) gebildet ist, wobei jede Reihe (138) von Auslösestreifen einen ersten Auslösestreifen, der in einem ersten Winkel in Bezug auf die erste Richtung (104) angeordnet ist, einen zweiten Auslösestreifen (106), der in einem zweiten Winkel in Bezug auf die erste Richtung (104) angeordnet ist, sowie einen dritten Auslösestreifen aufweist, der in einem dritten Winkel in Bezug auf die erste Richtung (104) angeordnet ist.

7. Passage nach Anspruch 6,
wobei jede Reihe (138) zwei Verbindungsstellen (140, 142) aufweist.

8. Passage nach Anspruch 6,
weiterhin aufweisend mindestens einen Spalt zwischen zwei der Auslösestreifen in mindestens einer der Reihen (138).

9. Passage nach einem der Ansprüche 1 bis 4,
wobei die Passage weiterhin eine erste Wand (116) und eine zweite Wand (120) aufweist, die der ersten Wand (116) gegenüberliegt;
sowie eine Mehrzahl der dreieckig ausgebildeten Regionen (112) zwischen den Wänden (116, 120) aufweist; und
wobei die Mehrzahl der Regionen (112) durch einen ersten Auslösestreifen (106'), der sich von einer ersten Stelle in der Nähe der einen der Wände (116) zu einer zweiten Stelle in der Nähe einer zweiten der Wände erstreckt, sowie durch ein Paar voneinander beabstandeter Auslösestreifen (106", 106"') gebildet ist, die in einem Winkel angeordnet sind, der den ersten Auslösestreifen (106') schneidet.

10. Passage nach einem der vorausgehenden Ansprüche,
wobei jede dreieckig ausgebildete Region (112) den Scheitelbereich sowie zwei Scheitelpunkte aufweist, die durch ein Paar der Auslösestreifen (106) und eine Wand (116) der Passage (102) gebildet sind.

11. Teil (98), aufweisend:
eine Passage (102) nach einem der vorausgehenden Ansprüche.

12. Teil nach Anspruch 11,
wobei das Teil (98) eine Turbinenmaschinenkomponente umfasst.

13. Teil nach Anspruch 11 oder 12,
wobei die Passage (102) eine Kühlpassage umfasst, in der ein Kühlfluid in der ersten Richtung (104) strömt.

## Revendications

1. Passage d'écoulement (102) par lequel un fluide s'écoule dans une première direction (104), ledit passage d'écoulement comprenant :
une pluralité de barrettes perturbatrices (106 ; 106', 106", 106"') placées à l'intérieur du passage d'écoulement (102) ; et
des barrettes perturbatrices adjacentes parmi lesdites barrettes perturbatrices étant orientées de manière à converger l'une vers l'autre au niveau d'une première extrémité pour former une partie apicale (108) et pour former une région (112) de forme triangulaire où une turbulence se crée ;
ledit passage d'écoulement étant **caractérisé en ce que :**
lesdites barrettes perturbatrices (106 ; 106', 106", 106"') sont espacées au niveau de ladite première extrémité pour définir une ouverture (110) dans ladite partie apicale par laquelle ledit fluide pénètre dans ladite région (112) ;
ladite partie apicale (108) est agencée de manière à ce que du fluide pénètre dans ladite région (112) de forme triangulaire par ladite ouverture (110) dans une direction formant un angle par rapport à ladite première direction (104) ; et
le fluide pénétrant par ladite ouverture forme deux cellules fluidiques (126, 128) qui se rejoignent pour former une seule cellule fluidique (130) à mesure que le fluide pénètre par l'ouverture (110), laquelle cellule se disperse sur l'ensemble de la région (112) de forme triangulaire et en occupe quasiment toute la surface pour y créer une turbulence maximale.

2. Passage d'écoulement selon la revendication 1, ledit angle étant un angle droit.

3. Passage d'écoulement selon la revendication 1 ou 2,
ladite région (112) comportant une partie de base au niveau d'une deuxième extrémité opposée à ladite première extrémité, et un axe de symétrie (115) entre ladite première extrémité et ladite deuxième extrémité étant transversal à ladite première direction (104) ; et
ladite partie de base étant située à proximité d'une paroi dudit passage d'écoulement.

4. Passage d'écoulement selon l'une quelconque des revendications précédentes :
ledit passage d'écoulement (102) comportant en outre des première et deuxième parois opposées (116, 120) ; et
ladite pluralité de barrettes perturbatrices (106) formant une pluralité desdites régions (112) de forme triangulaire dans la première direction (104), la partie apicale (108) d'une première desdites régions (112) de forme triangulaire étant adjacente à une première (116) desdites parois et la partie apicale (108) d'une deuxième desdites régions (112) de forme triangulaire étant adjacente à une deuxième (120) desdites parois.

5. Passage d'écoulement selon l'une quelconque des revendications 1 à 3,
ledit passage d'écoulement comportant en outre des première et deuxième parois opposées (116, 120) ; et
ladite pluralité de barrettes perturbatrices (106) formant une pluralité de régions alignées sur un axe transversal à ladite première direction (104).

6. Passage d'écoulement selon la revendication 5, ladite pluralité de régions de forme triangulaire étant formées d'au moins deux rangées (138) de barrettes perturbatrices (106), chacune desdites rangées (138) de barrettes perturbatrices comportant une première barrette perturbatrice (106) formant un premier angle par rapport à ladite première direction (104), une deuxième barrette perturbatrice (106) formant un deuxième angle par rapport à ladite première direction (104), et une troisième barrette perturbatrice formant un troisième angle par rapport à ladite première direction (104).

7. Passage d'écoulement selon la revendication 6, chaque rangée (138) comportant deux joints (140, 142).

8. Passage d'écoulement selon la revendication 6, comprenant en outre au moins un espace entre deux desdites barrettes perturbatrices dans au moins une des rangées (138).

9. Passage d'écoulement selon l'une quelconque des revendications 1 à 4, comprenant en outre :
une première paroi (116) et une deuxième paroi (120) opposée à ladite première paroi (116) ;
une pluralité desdites régions (112) de forme triangulaire entre lesdites parois (116, 120) ; et
ladite pluralité de régions (112) étant formées d'une première barrette perturbatrice (106') s'étendant d'un premier site proche d'une (116) desdites parois jusqu'à un deuxième site proche d'une deuxième (120) desdites parois et d'une paire de barrettes perturbatrices (106", 106"') espacées placées de manière à former un angle qui coupe la première barrette perturbatrice (106').

10. Passage d'écoulement selon l'une quelconque des revendications précédentes, chacune desdites régions (112) de forme triangulaire comportant ladite partie apicale et deux sommets formés d'une paire desdites barrettes perturbatrices (106) et d'une paroi (116) dudit passage d'écoulement (102).

11. Pièce (98), comprenant :
un passage d'écoulement (102) selon l'une quelconque des revendications précédentes.

12. Pièce (98) selon la revendication 11, comprenant un composant de moteur à turbine.

13. Pièce selon la revendication 11 ou 12, ledit passage d'écoulement (102) comprenant un passage d'écoulement de refroidissement par lequel s'écoule un fluide de refroidissement dans ladite première direction (104).
